# EUROPÄISCHE PATENTSCHRIFT

(11) **EP 1 966 891 B1**
(45) Veröffentlichungstag und Bekanntmachung des Hinweises auf die Patenterteilung: **24.11.2010**
(21) Anmeldenummer: 06841193.3
(22) Anmeldetag: 28.12.2006
(51) Int. Cl.: H03K 17/0412, H03K 17/567

(54) **EMITTER-GESCHALTETER BIPOLARTRANSISTOR**
EMITTER-SWITCHED BIPOLAR TRANSISTOR
TRANSISTOR BIPOLAIRE COMMUTE PAR L'EMETTEUR

(30) Priorität: 28.12.2005 DE 102005062755
(43) Veröffentlichungstag der Anmeldung: 10.09.2008
(73) Patentinhaber: voltwerk electronics GmbH, 20537 Hamburg (DE)
(72) Erfinder: OPPERMANN, HANS, 61118 Bad Vilbel (DE)
(74) Vertreter: UEXKÜLL & STOLBERG
(86) Internationale Anmeldenummer: PCT/EP2006/012573
(87) Internationale Veröffentlichungsnummer: WO 2007/073942

(56) Entgegenhaltungen:
- EP-B1- 0 190 931
- CHAN T K ET AL: "On the use of IGBT-gated GTO-cascode switches in quasi-resonant converters" INDUSTRY APPLICATIONS SOCIETY ANNUAL MEETING, 1993., CONFERENCE RECORD OF THE 1993 IEEE TORONTO, ONT., CANADA 2-8 OCT. 1993, NEW YORK, NY, USA,IEEE, US, 2. Oktober 1993 (1993-10-02), Seiten 1346-1352, XP010118906 ISBN: 0-7803-1462-X

## Beschreibung

Die Erfindung betrifft eine Schaltung gemäß Oberbegriff der Patentansprüche 1 oder 4.

Bei Wechselrichtern, Frequenzumrichtern, Stromversorgungen und sonstigen Leistungsanwendungen kommen überwiegend IGBTs (Insulated Gate Bipolar Transistors) zur Anwendung. Hierbei werden oft große Ströme bei hohen Betriebsspannungen geschaltet. Dabei tritt eine unerwünschte Wirkungsgradminderung durch langsame Schaltflanken und hohe Sättigungsspannungen sowie Stromschwanzverluste auf, die darauf zurückzuführen sind, dass der abklingende Laststrom und die volle Betriebsspannung zum Teil gleichzeitig anliegen.

Neben den IGBTs hat man auch bereits versucht, mit ESBT-Konfigurationen zu arbeiten. "ESBT" steht dabei für "emitter switched bipolar transistor". Hierbei ist dem NPN-Leistungstransistor ein MOS-Transistor nachgeschaltet, welcher die Aufgabe hat, den Emitterstrom des Bipolartransistors zu unterbrechen, wenn die Last abgeschaltet werden soll. Dies führt dazu, dass dann der Laststrom über die Kollektor-Basisdiode weitergeleitet wird, bis sich die Raumladungszone zwischen Basis und Kollektor wieder aufgebaut und der Transistor seine normale Sperrfähigkeit wiedererlangt hat. ESBTs haben aber den Nachteil gegenüber IGBTs, dass sie einen verhältnismäßig großen Basisstrom erfordern.

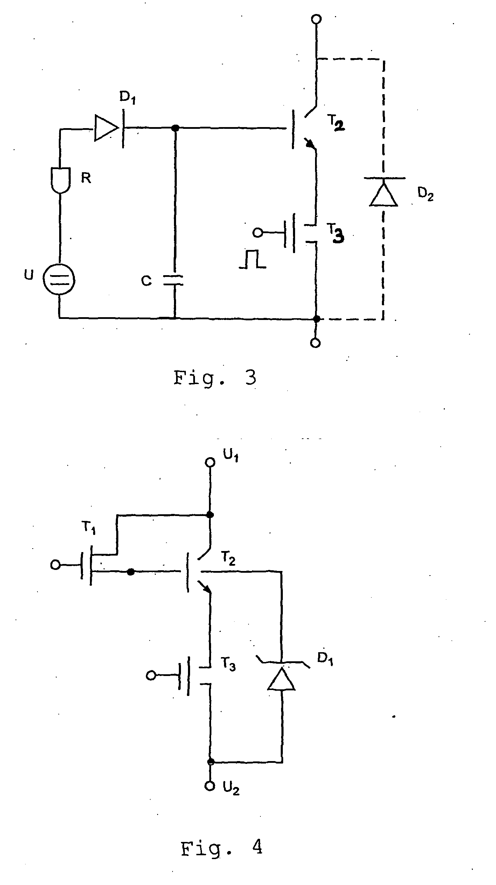

Von der ST_Microsystems ist ferner eine weiterentwickelte ESBT-Schaltung für kleinere Leistungen (im Bereich von 1 - 2 kW) bekannt, bei der ein Speicherkondensator zur Überwindung der Einschaltträgheit einen Stromstoß über eine Basis-Emitter-Diode des NPN-Transistors liefert und damit den NPN-Transistor in die Sättigung fährt. Erst nach einer Verzögerungszeit, die mit dem Ausräumen der Ladungsträger aus der Basiszone zu tun hat ist es möglich, den ESBT wieder abzuschalten. Dies kann aber im Kurzschlussfall zu spät sein (Fig. 3).

Aus der US 4,547,686 A ist eine Leistungsschaltung mit einem Emitter-gesteuerten Bipolartransistor (Q1) bekannt, dem ein MOS-Transistor (Q3) nachgeschaltet ist, wobei der Bipolartransistor (Q1) durch einen Mosfet-Transistor (Q2) angesteuert wird. Ein Nachteil dieser Schaltung besteht darin, daß sie nur in den ungesättigten Betrieb schalten kann.

Eine ähnliche Schaltung mit gleichen Nachteilen zeigt die DE 38 39 156 A1**.**

Die EP 0 190 931 B1 offenbart in Fig. 5 einen ESBT mit Mos-Treiber gemäß dem Oberbegriff von Anspruch 1 und weist darüber hinaus auch noch eine Freilaufdiode 5 antiparallel zum ESBT auf. Trotzdem wird ein Parallel-Rückwärtsstrom über die Basis-Kollektor-Strecke des ESBT nicht ausgeschlossen, da eine weitere Diode 8 vorgesehen ist, die nicht beidseitig begrenzend wirkt. Auch diese Entgegenhaltung kann den ESBT nur in den ungesättigten Betrieb schalten.

ESBTs sind seit über 20 Jahren bekannt, konnten sich aber trotz der guten Schalteigenschaften wegen der hohen Ansteuerströme nicht durchsetzen. Ein weiterer Mangel besteht darin, dass ESBTs nicht in Halb- und Vollbrücken und auch nicht in Dreiphasen Topologien eingesetzt werden können, da Rückströme diese stören oder zerstören können.

**Aufgabe** der Erfindung ist es, diese zuvor genannten Mängel zu überwinden.

Zur **Lösung** dieser Aufgabe dient eine veränderte ESBT-Schaltung, die die Merkmale des Patentanspruchs 1 bzw. komplementär dazu die Merkmale des Patentanspruchs 4 aufweist.

Vorteilhafte Ausgestaltungen der Erfindung sind Gegenstand der Unteransprüche.

Die Erfindung wird nachfolgend anhand einer Zeichnung näher erläutert; es zeigen:
- **Figur 1**: eine bekannte IGBT-Schaltung;
- **Figur 2**: eine bekannte ESBT-Schaltung;
- **Figur 3**: eine weitere bekannte ESBT-Schaltung;
- **Figur 4**: eine erste Ausführungsform einer erfindungsgemäß verbesserten ESBT-Schaltung;
- **Figur 5**: eine zweite Ausführungsform der Erfindung;
- **Figur 6**: eine Abwandlung der ersten Ausführungsform nach Fi- gur 4; und
- **Figur 7**: eine Abwandlung der zweiten Ausführungsform nach Fi- gur 5.

In den Figuren sind gleiche Teile mit gleichen Bezugszeichen dargestellt und bezeichnet.

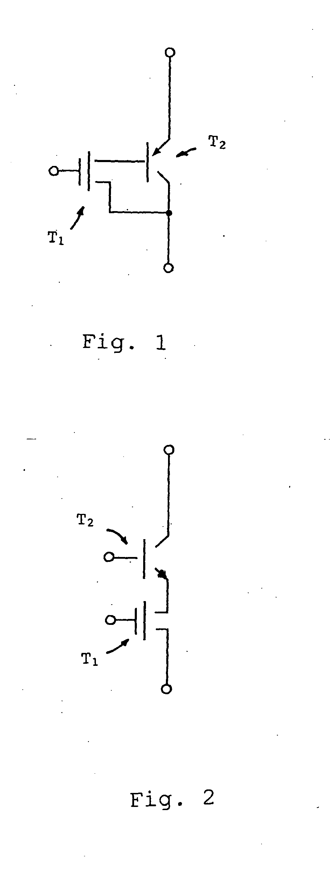

**Figur 1** zeigt das Wirkungsschaltbild eines bekannten IGBTs. Man erkennt einen Treibermosfet T₁, gefolgt von einem PNP-Transistor T₂. Beim Einschalten bestimmt der Treibermosfet T₁ zunächst die Schaltgeschwindigkeit für den Laststrom. Der nachgesetzte PNP-Transistor T₂ schaltet mit einer Verzögerung zu. Die Verzögerung resultiert daraus, dass die Basisregion erst mit Ladungsträgern durchflutet werden muss, bis die Basis-Kollektor-Raumladungszone abgebaut und der PNP-Transistor T₂ leitend geworden ist. Damit reduziert sich die Sättigungsspannung des IGBTs nochmals. Beim Abschalten reagiert der Mosfet T₁ sehr schnell. Der PNP-Transistor T₂ folgt aber der Abschaltung erst, wenn durch den Laststrom die Ladungsträger aus der Basisregion wieder entzogen worden sind. Dieses Abklingen des Kollektorstromes nennt man auch "Stromschwanz". Gerade bei Hochstrom-IGBTs mit mehreren hundert Ampere begrenzt dieser Umstand die Grenzfrequenz des Halbleiters enorm, da zum Teil abklingender Laststrom und volle Betriebsspannung gleichzeitig anliegen.

**Figur 2** zeigt eine bekannte ESBT-Schaltung, bei der dem NPN-Leistungstransistor T₂ ein MOS-Transistor T₃ nachgeschaltet ist, der die Aufgabe hat, den Emitterstrom aus dem NPN-Leistungstransistor T₂ zu unterbrechen, wenn die Last abgeschaltet werden soll. Dies führt dazu, dass dann der Laststrom über die Kollektor-Basisdiode weitergeleitet wird, bis sich die Raumladungszone zwischen Basis und Kollektor wieder aufge-baut und der Transistor seine normale Sperrfähigkeit wiedererlangt hat. ESBTs haben aber den Nachteil gegenüber IGBTs, dass sie einen verhältnismäßig großen Basisstrom erfordern.

**Figur 3** zeigt eine von ST_Microsystems entwickelten ESBT-Schaltung für kleinere Leistungen von 1 - 2 kW. Die Zeichnung macht deutlich, dass neben dem Einschalten des Emitter MOS-Transistors T₃ die Basis des NPN-Transistors T₂ mit einem Strom von 1/5 I_{c} angesteuert werden muss, um eine ausreichend niedrige Sättigungsspannung Uceₛₐₜₜ zu erreichen. Dies wären bei einem 30A ESBT dann 6A Basisstrom und es zeigt den großen Nachteil gegenüber dem IGBT in Bezug auf die Ansteuerleistung. Ferner ergibt sich noch ein Problem beim Einschalten des EBTs. Zur Überwindung der Einschaltträgheit wird ein Stromstoß aus dem Speicher-Kondensator C über eine Basis-Emitter-Diode von T₂ gezogen und fährt den T₂ in die Sättigung. Erst nach einer Verzögerungszeit, die mit dem Ausräumen der Ladungsträger aus der Basiszone zu tun hat ist es möglich, den ESBT wieder abzuschalten. Dies kann aber im Kurzschlussfall zu spät sein.

### Lösung der Probleme von ESBT-Konfigurationen:

**Figur 4** zeigt eine veränderte ESBT-Konfiguration. Hierbei schalten der Treibermosfet T₁ und der Emitter Switch T₃ den gesamten Laststrom über die Basis-Emitter-Diode von dem NPN-Transistor T₂. Dies führt zwar zur schnellen Einschaltung des Laststromes, aber eine niedrige Sättigungsspannung stellt sich erst ein, wenn der NPN-Transistor T₂ durch den Basisstrom die Raumladungszone der Basis-Kollektor-Diode abgebaut hat. Beim Abschalten des ESBTs werden zunächst wieder T₁ und T₃ gesperrt. Der sich dann einstellende Kollektor-Basis-Rückwärtsstrom wird über die bidirektionale Begrenzerdiode (Transzorb-Diode) D₁ weitergeführt und die Spannung an der Basis von T₂ auf ein optimales Maß begrenzt, um auch einen Spannungsschutz für den T₃ zu erzielen und um einen Rückstrom aus dem Lastkreis über die Basis-Kollektor-Diode von T₂ zu verhindern. Nach einer Zeit t_{d} schaltet dann der T₂ mit einer sehr steilen Strom- und Spannungsflanke ab.

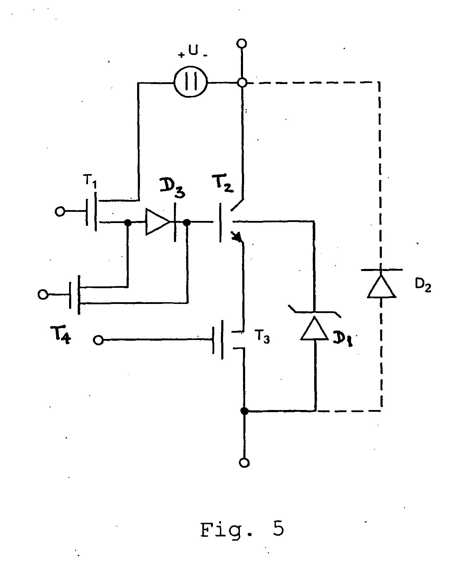

**Figur 5** zeigt eine weitere Ausgestaltung des ESBTs derart, dass in Reihe zum Treibermosfet T₁ eine Spannungsquelle U zwischen Kollektor von T₂ und dem Drain von T₁ gelegt ist. Die Spannungsquelle U hilft mit, den Transistor T₂ von der Quasi-Sättigung in eine sehr niedrige Sättigungsspannung steuern zu können. Die Diode D₃ Reihe zum Source-Anschluss von T₁ wird als Gegenspannungsquelle zu U genutzt, um den T₂ auch in die Quasi-Sättigung fahren zu können.

Beim Einschalten wird der Schalter T4 zunächst offen bleiben bis der T₂ zugeschaltet hat, d. h. sich in der Quasi-Sättigung befindet. Danach wird die Diode D3 vom Schalter T₄ überbrückt und der T₂ kann bis zu einer sehr kleinen Sättigungsspannung hinuntergefahren werden.

Beim Abschalten wird zunächst nur der Schalter T4 geöffnet und der Transistor T₂ in die Quasi-Sättigung zurückgefahren. Danach öffnet auch T₁ und T₄ und der T₂ schaltet sehr schnell ab.

Weitere ESBT-Varianten ergeben sich wenn der Bipolartransistor T₂ ein PNP-Transistor ist.

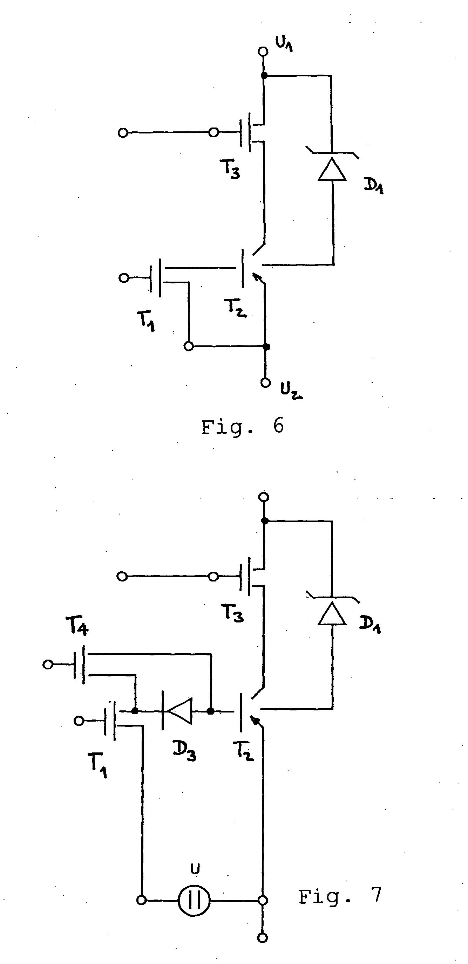

**Figur 6** zeigt eine entsprechend analoge Ausgestaltungen der Schaltung von Figur 4, wobei der Transistor T2 ein PNP-Transistor ist.

**Figur 7** zeigt eine analoge Ausgestaltungen der Schaltung von Figur 5, bei der der Bipolartransistor T2 ebenfalls wieder ein PNP-Transistor ist.

## Patentansprüche

1. Leistungsschaltung mit einem Emitter-gesteuerten Bipolartransistor (T2), dem ein MOS-Transistor (T3) nachgeschaltet ist;
wobei der Bipolartransistor (T2) durch einen Mosfet-Transistor (T1) angesteuert wird; und
wobei eine Begrenzerdiode (D1) zwischen dem Ausgang des MOS-Transistors (T3) und der Basis des Bipolartransistors (T2) liegt, die den Rückstrom der Basis-Kollektor-Diode des Bipolartransistors (T2) zum Fußpunkt des ESBT weiterleitet;
**dadurch gekennzeichnet, daß** eine Spannungsquelle (U) zwischen den Kollektor des Bipolartransistors (T2) und die Drain des Mosfet-Transistors (T1) eingefügt ist.

2. Leistungsschaltung nach Anspruch 1, **dadurch gekennzeichnet, dass** die Begrenzerdiode (D1) eine symmetrische Begrenzerdiode ist mit Sperrfähigkeit in zwei Richtungen und dass so ein Rückwärtsstrom über die Basis-Kollektor-Diode des Bipolartransistors (T2) verhindert wird.

3. Leistungsschaltung nach Anspruch 1, **dadurch gekennzeichnet, dass** dem Treiber-Mosfet (T1) eine Diode (D3) an der Source folgt und dass diese durch einen Parallel-Mosfet (T4) überbrückt werden kann, wobei beim Einschalten der Parallel-Mosfet (T4) offen bleibt, damit sich der Bipolartransistor (T2) für eine sichere Betriebsweise zunächst nur in den quasigesättigten Zustand begibt, während erst danach der Parallel-Mosfet (T4) die Diode (D3) überbrückt und der Bipolartransistor (T2) in die Sättigung gefahren wird; während beim Abschalten der Parallel-Mosfet (T4) wieder geöffnet und der Bipolartransistor (T2) in den quasigesättigten Betrieb geführt wird, um sodann durch den Treiber-Mosfet (T1) und MOS-Transistors (T3) verlustarm und schnell abgeschaltet werden zu können.

4. Leistungsschaltung mit einem Emitter-gesteuerten Bipolartransistor (T2), dem ein MOS-Transistor (T3) vorgeschaltet ist;
wobei der Bipolartransistor (T2) durch einen Mosfet-Transistor (T1) angesteuert wird; und
wobei eine Begrenzerdiode (D1) zwischen dem Eingang des MOS-Transistors (T3) und der Basis des Bipolartransistors (T2) liegt, die den Rückstrom der Basis-Kollektor-Diode des Bipolartransistors (T2) zum Fußpunkt des ESBT weiterleitet;
**dadurch gekennzeichnet, daß** eine Spannungsquelle (U) zwischen den Emitter des Bipolartransistors (T2) und die Drain des Mosfet-Transistors (T1) eingefügt ist.

5. Leistungsschaltung nach Anspruch 4, **dadurch gekennzeichnet, dass** die Begrenzerdiode (D1) eine symmetrische Begrenzerdiode ist mit Sperrfähigkeit in zwei Richtungen und dass so ein Rückwärtsstrom über die Basis-Kollektor-Diode des Bipolartransistors (T2) verhindert wird.

6. Leistungsschaltung nach Anspruch 4, **dadurch gekennzeichnet, dass** dem Treiber-Mosfet (T1) eine Diode (D3) an der Source folgt und dass diese durch einen Parallel-Mosfet (T4) überbrückt werden kann, wobei beim Einschalten der Parallel-Mosfet (T4) offen bleibt, damit sich der Bipolartransistor (T2) für eine sichere Betriebsweise zunächst nur in den quasigesättigten Zustand begibt, während erst danach der Parallel-Mosfet (T4) die Diode (D3) überbrückt und der Bipolartransistor (T2) in die Sättigung gefahren wird; während beim Abschalten der Parallel-Mosfet (T4) wieder geöffnet und der Bipolartransistor (T2) in den quasigesättigten Betrieb geführt wird, um sodann durch den Treiber-Mosfet (T1) und MOS-Transistors (T3) verlustarm und schnell abgeschaltet werden zu können.

## Claims

1. Power circuit comprising an emitter-switched bipolar transistor (T2), having a MOS-transistor (T3) connected thereto in downstream directions;
with the bipolar transistor (T2) being controlled by a Mosfet-transistor (T1); and
wherein a limiter diode (D1) is connected between the outlet of the MOS-transistor (T3) and the base of the bipolar transistor (T2) and which directs the back current from the base-collector-diode of the bipolar transistor (T2) the base point of the ESBT;
**characterized in that** a voltage source (U) is connected between the collector of the bipolar transistor (T2) and the drain of the Mosfet-transistor (T1).

2. Power circuit according to claim 1, **characterized in that** the limiter diode (D1) is a symmetrically acting limiter diode with shutting-off characteristics in two direction so that back current is prevented via the base-collector-diode of the bipolar transistor (T2).

3. Power circuit according to claim 1, **characterized in that** a diode (D3) connected to the source of the Mosfet (T1) follows the driver Mosfet (T1) and that said diode can be shunted by a parallel Mosfet (T4), wherein upon switch-on the parallel Mosfet (T4) remains conducting so that the bipolar transistor (T2) moves into a quasi-saturated condition to achieve a secure operation, while only thereafter the parallel Mosfet (T4) shortcuts the diode (D3) and the bipolar transistor (T2) is driven into saturation; wherein upon switching off the parallel Mosfet (T4) is opened again and the bipolar transistor (T2) is driven into the quasi-saturated condition to be switched off with little losses and rapidly by the driver Mosfet (T1) and the MOS-transistor (T3).

4. Power circuit comprising an emitter-switched bipolar transistor (T2), having a MOS-transistor (T3) connected thereto in downstream directions;
with the bipolar transistor (T2) being controlled by a Mosfet-transistor (T1); and
wherein a limiter diode (D1) is connected between the outlet of the MOS-transistor (T3) and the base of the bipolar transistor (T2) and which directs the back current from the base-collector-diode of the bipolar transistor (T2) the base point of the ESBT;
**characterized in that** a voltage source (U) is connected between the emitter of the bipolar transistor (T2) and the drain of the Mosfet-transistor (T1).

5. Power circuit according to claim 4, **characterized in that** the limiter diode (D1) is a symmetrically acting limiter diode with shutting-off characteristics in two direction so that back current is prevented via the base-collector-diode of the bipolar transistor (T2).

6. Power circuit according to claim 4, **characterized in that** a diode (D3) connected to the source of the driver Mosfet (T1) follows the driver Mosfet (T1) and that said diode can be shunted by a parallel Mosfet (T4), wherein upon switching-on the parallel Mosfet (T4) remains conducting so that the bipolar transistor (T2) firstly moves into the quasi-saturated condition to achieve a secure operation, while only thereafter the parallel Mosfet (T4) shortcuts the diode (D3) and the bipolar transistor (T2) is driven into saturation; while upon switching off the parallel Mosfet (T4) is opened again and the bipolar transistor (T2) is moved into the quasi-saturated condition to be switched off with little losses and rapidly by the driver Mosfet (T1) and the MOS-transistor (T3).

## Revendications

1. Commutation de puissance avec un transistor bipolaire (T2) commuté par l'émetteur par rapport auquel un transistor MOS (T3) est placé en aval,
le transistor bipolaire (T2) étant excité par un transistor MOSFET (T1) et
une diode de limiteur (D1) étant située entre la sortie du transistor MOS (T3) et la base du transistor bipolaire (T2) qui transmet le courant de retour de la diode collecteur-base du transistor bipolaire (T2) à la base de l'ESBT,
**caractérisée en ce qu'**une source de tension (U) est insérée entre le collecteur du transistor bipolaire (T2) et le drain du transistor MOSFET (T1).

2. Commutation de puissance selon la revendication 1, **caractérisée en ce que** la diode de limiteur (D1) est une diode de limiteur symétrique avec capacité de blocage dans les deux sens et qu'un courant de retour par la diode collecteur-base du transistor bipolaire (T2) est ainsi évité.

3. Commutation de puissance selon la revendication 1, **caractérisée en ce qu'**une diode (D3) à la source suit le pilote de MOSFET (T1) et que celle-ci peut être surmontée par un MOSFET parallèle (T4) cependant que, lors de la mise en circuit, le MOSFET parallèle (T4) reste ouvert pour que le transistor bipolaire (T2), pour un fonctionnement sûr, ne se mette tout d'abord que dans l'état quasi-saturé tandis que ce n'est qu'après que le MOSFET parallèle (T4) surmonte la diode (D3) et que le transistor bipolaire (T2) est mis en saturation alors que, lors de la mise hors circuit, le MOSFET parallèle (T4) est ouvert à nouveau et le transistor bipolaire (T2) est guidé en mode quasi-saturé pour pouvoir être immédiatement arrêté sans perte et rapidement par le pilote de MOSFET (T1) et le transistor MOS (T3).

4. Commmutation de puissance avec un transistor bipolaire (T2) commuté par l'émetteur par rapport auquel un transistor MOS (T3) est placé en aval,
le transistor bipolaire (T2) étant excité par un transistor MOSFET (T1) et
une diode de limiteur (D1) étant située entre l'entrée du transistor MOS (T3) et la base du transistor bipolaire (T2) qui transmet le courant de retour de la diode collecteur-base du transistor bipolaire (T2) à la base de l'ESBT,
**caractérisée en ce qu'**une source de tension (U) est insérée entre l'émetteur du transistor bipolaire (T2) et le drain du transistor MOSFET (T1).

5. Commutation de puissance selon la revendication 4, **caractérisée en ce que** la diode de limiteur (D1) est une diode de limiteur symétrique avec capacité de blocage dans les deux sens et qu'un courant de retour par la diode collecteur-base du transistor bipolaire (T2) est ainsi évité.

6. Commutation de puissance selon la revendication 4, **caractérisée en ce qu'**une diode (D3) à la source suit le pilote de MOSFET (T1) et que celle-ci peut être surmontée par un MOSFET parallèle (T4) cependant que, lors de la mise en circuit, le MOSFET parallèle (T4) reste ouvert pour que le transistor bipolaire (T2), pour un fonctionnement sûr, ne se mette tout d'abord que dans l'état quasi-saturé tandis que ce n'est qu'après que le MOSFET parallèle (T4) surmonte la diode (D3) et que le transistor bipolaire (T2) est mis en saturation alors que, lors de la mise hors circuit, le MOSFET parallèle (T4) est ouvert à nouveau et le transistor bipolaire (T2) est guidé en mode quasi-saturé pour pouvoir être immédiatement arrêté sans perte et rapidement par le pilote de MOSFET (T1) et du transistor MOS (T3).
